# EUROPEAN PATENT APPLICATION

(11) **EP 4 730 649 A1**
(43) Date of publication of application: **22.04.2026**
(21) Application number: 24844341.8
(22) Date of filing: 16.05.2024
(51) Int. Cl.: H03F 1/32

(54) **POWER AMPLIFIER, CONTROL METHOD, RADIO FREQUENCY PROCESSING SYSTEM, AND SIGNAL TRANSMITTING DEVICE**

(30) Priority: 24.07.2023 CN 202310921145
(71) Applicant: Huawei Technologies Co., Ltd., Shenzhen, Guangdong 518129 (CN)
(72) Inventor: LV, Jia, Shenzhen, Guangdong 518129 (CN); SUN, Jie, Shenzhen, Guangdong 518129 (CN); LIU, Wenju, Shenzhen, Guangdong 518129 (CN); CHEN, Dong, Shenzhen, Guangdong 518129 (CN); FENG, Yun, Shenzhen, Guangdong 518129 (CN); MAI, Jiechao, Shenzhen, Guangdong 518129 (CN); PAN, Zhou, Shenzhen, Guangdong 518129 (CN)
(74) Representative: Pfenning, Meinig & Partner mbB
(86) International application number: PCT/CN2024/093673
(87) International publication number: WO 2025/020645

(57) **Abstract**

This application provides a power amplifier, a control method, a radio frequency processing system, and a signal transmission apparatus, used in the field of wireless communication technologies. The power amplifier includes a gate bias circuit, a drain bias circuit, and a power transistor. The gate bias circuit includes a first power supply interface and a second power supply interface. A specific voltage difference exists between a first voltage signal received by an input end of the first power supply interface and a second voltage signal received by an input end of the second power supply interface. A gate of the power transistor is configured to receive a radio frequency signal, and the radio frequency signal carries a plurality of signal slice symbols. When a first signal slice symbol carries valid data, the gate of the power transistor is coupled to an output end of the first power supply interface. When the first signal slice symbol carries no valid data or no radio frequency signal is received, the gate of the power transistor is coupled to an output end of the second power supply interface. In this application, a gate bias voltage signal is adjusted based on a data volume, thereby greatly reducing a waste of power consumption of the power amplifier.

## Description

This application claims priority to Chinese Patent Application No. 202310921145.4, filed with the China National Intellectual Property Administration on July 24, 2023 and entitled "POWER AMPLIFIER, CONTROL METHOD, RADIO FREQUENCY PROCESSING SYSTEM, AND SIGNAL TRANSMISSION APPARATUS", which is incorporated herein by reference in its entirety.

### TECHNICAL FIELD

This application relates to the field of wireless communication technologies, and in particular, to a power amplifier, a control method, a radio frequency processing system, and a signal transmission apparatus.

### BACKGROUND

A power amplifier includes a gate bias circuit, a drain bias circuit, and at least one power transistor. The gate bias circuit is coupled to a gate of the power transistor to output a gate bias voltage signal. The drain bias circuit is coupled to a drain of the power transistor to output a drain direct current signal (for example, a drain bias voltage signal or a drain bias current signal). The gate bias voltage signal and the drain direct current signal are used to control the at least one power transistor to be biased in an amplification state. When the power transistor operates in the amplification state, the gate of the power transistor receives a first radio frequency signal. The first radio frequency signal carries a plurality of signal slice symbols. In this case, the gate bias voltage signal may control conduction of a channel between a source and the drain of the power transistor, to change a signal power of a second radio frequency signal output by the drain of the power transistor. Thus, the second radio frequency signal has a gain amplification factor relationship with the first radio frequency signal, that is, the first radio frequency signal is subject to power amplification to generate the second radio frequency signal. However, in actual operation, a data volume carried on the signal slice symbol varies due to different factors such as user quantities, service interaction types, and used network protocols. Different data volumes result in different magnitudes of a signal power of the first radio frequency signal. Based on a design principle of the power amplifier in actual application, a signal power of most first radio frequency signals needs to be within a medium-to-low power range of the power amplifier. However, in the medium-to-low power range, conversion utilization (namely, efficiency of the power amplifier) of a supply power (namely, a supply power of the drain direct current signal) of the power amplifier is very low, which causes a substantial waste of power consumption. Power consumption of the power amplifier is the largest source of power consumption in wireless communication.

To reduce the power consumption of the power amplifier, one improvement is to incorporate an average power tracking circuit in the power amplifier. The average power tracking circuit adjusts, based on variations of an output power of the second radio frequency signal, magnitude of the drain direct current signal output by the drain bias circuit, so as to improve conversion utilization of the drain direct current signal while maintaining normal power amplification, and to reduce the power consumption of the power amplifier. However, this approach suffers a high control delay and slow control response, resulting in only a limited reduction in power consumption.

### SUMMARY

Embodiments of this application provide a power amplifier, a control method, a radio frequency processing system, and a signal transmission apparatus, to greatly reduce power consumption of the power amplifier.

To achieve the foregoing objectives, embodiments of this application provide the following technical solutions.

According to a first aspect, a power amplifier is provided. The power amplifier includes a gate bias circuit, a drain bias circuit, and at least one power transistor. The drain bias circuit is coupled to a drain of the at least one power transistor. The gate bias circuit includes a first power supply interface and a second power supply interface. A specific voltage difference exists between a first voltage signal received by an input end of the first power supply interface and a second voltage signal received by an input end of the second power supply interface. A gate of the at least one power transistor is configured to receive a radio frequency signal, and the radio frequency signal carries a plurality of signal slice symbols. When a first signal slice symbol carries valid data, the gate of the at least one power transistor is coupled to an output end of the first power supply interface. When the first signal slice symbol carries no valid data or no radio frequency signal is received, the gate of the at least one power transistor is coupled to an output end of the second power supply interface.

In embodiments of this application, the drain bias circuit outputs a drain direct current signal (for example, a drain bias voltage signal or a drain bias current signal) to the drain of the power transistor. The gate bias circuit outputs a gate bias voltage signal to the gate of the power transistor. The power transistor is controlled to be in an amplification state by using the gate bias voltage signal and the drain direct current signal. When the power transistor is in the amplification state, the gate of the power transistor receives the radio frequency signal, and the radio frequency signal may be output from the drain based on the drain direct current signal of the drain of the power transistor. The radio frequency signal output by the drain and the radio frequency signal received by the gate have a gain amplification relationship, namely, a power amplification relationship. No matter whether the power transistor receives the radio frequency signal, the drain of the power transistor always has the drain direct current signal. The drain direct current signal is regarded as a supply power of the power transistor. Therefore, a ratio of a power of the radio frequency signal output by the drain of the power transistor to the supply power may be regarded as efficiency of the power transistor. Higher efficiency of the power transistor indicates higher utilization of the supply power of the power amplifier. Lower efficiency of the power transistor indicates higher power consumption of the power amplifier. When the gate of the power transistor does not output the radio frequency signal, or the first signal slice symbol corresponding to the received radio frequency signal carries no valid data, the power amplifier is in an idle state. In the idle state, the efficiency of the power transistor is extremely low, and a waste of power consumption is quite high. The first voltage signal and the second voltage signal, which have the specific voltage difference, are set. When the first voltage signal is used as the gate bias voltage signal, a conduction width of a channel between the drain and a source of the power transistor is a first width. When the second voltage signal is used as the gate bias voltage signal, the conduction width of the channel between the drain and the source of the power transistor is a second width. The first width is greater than the second width. The greater channel conduction width of the power transistor indicates a higher voltage or current on the drain. In actual application, when the first signal slice symbol carries no valid data or no radio frequency signal is received, the power amplifier is in the idle state. In this case, the voltage or the current of the drain of the power transistor may be reduced based on the second voltage signal, and thus the power consumption of the drain is reduced. When the first signal slice symbol carries the valid data, the voltage or the current of the drain of the power transistor allows normal power amplification of the power amplifier based on the first voltage signal. Through the foregoing operations, a waste of power consumption in the idle state can be greatly reduced.

In a possible implementation, the gate bias circuit further includes a voltage adjusting circuit. The voltage adjusting circuit is configured to: when the first signal slice symbol carries the valid data, adjust a magnitude of the first voltage signal to a first voltage value. The first voltage value corresponds to a data volume range within which the valid data carried on the first signal slice symbol is. In embodiments of this application, when the first signal slice symbol corresponding to the radio frequency signal received by the power transistor carries the valid data, it indicates that the power amplifier operates in a data load state. However, in actual application, a data volume of each signal slice symbol varies due to factors such as a user quantity, a service volume, and a network protocol. A smaller data volume of the signal slice symbol indicates a smaller power of a corresponding radio frequency signal. To avoid an enormous waste of power consumption at the drain in a process of performing power amplification on a radio frequency signal with a small data volume, a plurality of data volume ranges may be divided based on the data volume, and a corresponding voltage value is set for each data volume range. Different voltage values cause different channel conduction widths of the power transistor. Under different channel conduction widths, when normal power amplification is performed on a radio frequency signal of a corresponding power, a waste of power consumption at the drain is reduced as much as possible. In actual operation, the first voltage signal may be adjusted, based on the data volume range within which the valid data carried on the first signal slice symbol on the received radio frequency signal is, to the first voltage value corresponding to the data volume range through the voltage adjusting circuit, and the first voltage signal with the first voltage value is used as the gate bias voltage signal and output to the gate of the power transistor.

In a possible implementation, the voltage adjusting circuit is a voltage divider circuit. The voltage divider circuit includes a plurality of voltage divider output ends. The plurality of voltage divider output ends are in one-to-one correspondence with a plurality of data volume ranges. When the first signal slice symbol carries the valid data and a data volume of the valid data is within a first data volume range, an input end of the voltage divider circuit is coupled to the output end of the first power supply interface, and the gate of the at least one power transistor is in conduction with a first voltage divider output end. The first voltage divider output end is a voltage divider output end corresponding to the first data volume range. In embodiments of this application, voltage division may be performed on the first voltage signal through the voltage divider circuit, to obtain first voltage signals with voltage values corresponding to different data volume ranges. The first voltage signals with corresponding voltage values are output by the plurality of voltage divider output ends respectively.

In a possible implementation, the voltage divider circuit includes a resistor ladder. The resistor ladder includes a plurality of equivalent resistors. The plurality of equivalent resistors are connected in series. A first end of the resistor ladder is the input end of the voltage divider circuit. The plurality of equivalent resistors are coupled to the plurality of voltage divider output ends respectively. In embodiments of this application, voltage division may be implemented by using the resistor ladder. The resistor ladder includes the plurality of equivalent resistors connected in series. Each equivalent resistor can perform voltage division on an input voltage. The plurality of voltage divider output ends of the voltage divider circuit are coupled to the plurality of equivalent resistors, so that the first voltage signals with different voltage values are output by the plurality of voltage divider output ends.

In a possible implementation, the power amplifier further includes a first gating switch. The plurality of voltage divider output ends are coupled to the gate of the at least one power transistor via the first gating switch. In embodiments of this application, gating coupling may be implemented at the plurality of voltage divider output ends via the first gating switch, to output the first voltage signal with a specific voltage value to the gate of the power transistor.

In a possible implementation, when the first signal slice symbol carries no valid data or no radio frequency signal is received, the first gating switch is directly connected to the output end of the second power supply interface. In embodiments of this application, when the gate of the power transistor is coupled to the output end of the second power supply interface, the voltage divider circuit may perform voltage division on the second voltage signal output by the second power supply interface, so that a voltage of a subsequent stage of the voltage divider circuit is elevated. In this case, in a process of performing power amplification on the received radio frequency signal, more bottom noise may be generated on the output radio frequency signal, which affects data accuracy and the like. The first gating switch is directly connected to the second power supply interface, to avoid generating bottom noise and the like.

In a possible implementation, the gate bias circuit includes a first power supply. An output end of the first power supply is coupled to the input end of the first power supply interface. The voltage adjusting circuit includes a plurality of reference power supplies. A plurality of reference output ends corresponding to the plurality of reference power supplies are configured to output a plurality of reference voltages. The plurality of reference voltages have different voltage values, and the plurality of reference voltages correspond to a plurality of data volume ranges. When the first signal slice symbol carries the valid data and a data volume of the valid data is within a first data volume range, a voltage input end of the first power supply is coupled to a first reference output end. The first reference output end is a reference output end corresponding to the first data volume range. In embodiments of this application, the first power supply is configured to provide the first voltage signal for the input end of the first power supply interface. The first voltage signal output by the first power supply may be adjusted to obtain first voltage signals with different voltage values. In this case, the voltage adjusting circuit may include the plurality of reference power supplies. The plurality of reference power supplies may correspondingly output the plurality of reference voltages with different voltage values. Each reference voltage corresponds to one data volume range of the signal slice symbol. In actual application, a corresponding reference voltage is selected based on a data volume range corresponding to the first signal slice symbol. The selected reference voltage is used as an operating voltage of the first power supply, to control the first power supply to output the first voltage signal corresponding to the first voltage value. The voltage value of the first voltage signal is adjusted, to reduce a waste of power consumption of the drain of the power transistor in the data load state as much as possible.

For example, the first power supply may be a digital-to-analog converter, a charge pump voltage conversion circuit, a voltage source, a low dropout regulator, or the like.

In a possible implementation, the power amplifier further includes a first gating switch. The plurality of reference output ends corresponding to the plurality of reference power supplies are coupled to the voltage input end of the first power supply via the first gating switch. In embodiments of this application, a reference voltage source may be selected via the first gating switch, to obtain reference voltages with different voltage values. The voltage value of the first voltage signal is adjusted based on the reference voltages with the different voltage values.

In a possible implementation, the plurality of reference power supplies are a plurality of digital registers. In embodiments of this application, a constant reference voltage may be output by using the digital register. The plurality of digital registers output the reference voltages with the different voltage values.

In a possible implementation, when data volumes carried on a plurality of adjacent signal slice symbols are within at least two data volume ranges, a second data volume range serves as an actual data volume range of the plurality of adjacent signal slice symbols. The second data volume range is a highest data volume range in the at least two data volume ranges. In this embodiment of this application, when switching selection is performed on the first voltage signals with the different voltage values, specific switching time is required. In a scenario that has a specific requirement for transmission precision or the like, an operation of switching the first voltage signal causes a specific delay, which affects data transmission precision. In this case, switching of the voltage value of the first voltage signal may not be performed between the plurality of (for example, two or three) adjacent signal slice symbols. A voltage value corresponding to a highest data volume range of the plurality of adjacent signal slice symbols may be used as the voltage value of the first voltage signal. The voltage value can ensure that high-precision power amplification is implemented for the plurality of adjacent signal slice symbols.

In a possible implementation, the power amplifier further includes a second gating switch. The gate of the at least one power transistor is coupled, via the second gating switch, to the output end of the first power supply interface or to the output end of the second power supply interface. In embodiments of this application, conduction with the output end of the first power supply interface or conduction with the output end of the second power supply interface is selected via the second gating switch, so as to select the first voltage signal or the second voltage signal.

According to a second aspect, embodiments of this application further provide a control method based on a power amplifier. The power amplifier includes at least one power transistor. The method includes: a gate of the at least one power transistor is configured to receive a radio frequency signal and a gate bias voltage signal. A drain of the at least one power transistor receives a drain bias voltage signal. The radio frequency signal carries a plurality of signal slice symbols. When a first signal slice symbol carries valid data, the gate bias voltage signal is controlled to be a first voltage signal based on a control signal. When the first signal slice symbol carries no valid data or no radio frequency signal is received, the gate bias voltage signal is controlled to be a second voltage signal based on the control signal. A specific voltage difference exists between the first voltage signal and the second voltage signal.

In a possible implementation, the method further includes: adjusting, when the first signal slice symbol carries the valid data, a magnitude of the first voltage signal to a first voltage value based on the control signal. The first voltage value corresponds to a data volume range within which the valid data carried on the first signal slice symbol is.

In a possible implementation, the adjusting the magnitude of the first voltage signal to the first voltage value based on the control signal further includes: setting, when data volumes carried on a plurality of adjacent signal slice symbols are within at least two data volume ranges, a voltage value of the first voltage signal to a voltage value corresponding to a second data volume range. The second data volume range is a highest data volume range in the at least two data volume ranges.

In a possible implementation, the method further includes: inputting a first indication signal, where the first indication signal indicates a data volume of valid data carried on the plurality of signal slice symbols; and obtaining the control signal based on the first indication signal.

According to a third aspect, embodiments of this application further provide a radio frequency processing system. The radio frequency processing system includes a radio frequency generation circuit and the power amplifier described in the first aspect. An output end of the radio frequency generation circuit is coupled to an input end of the power amplifier. The radio frequency generation circuit is configured to output a radio frequency signal. The radio frequency signal carries a plurality of signal slice symbols. The power amplifier is configured to perform power amplification on the radio frequency signal.

In a possible implementation, a baseband processing circuit includes a controller. The controller is configured to output a control signal to the radio frequency processing system. The control signal is used for adjusting a magnitude of a gate bias voltage signal of a power transistor of the radio frequency processing system. In embodiments of this application, when generating a first baseband signal based on the plurality of signal slice symbols, the baseband processing circuit may generate the control signal, and output the control signal to the power amplifier, to adjust the gate bias voltage signal. The controller may be an existing component in the baseband processing circuit, and only related software or hardware circuit needs to be modified in the controller, to generate the control signal. A related control signal is generated based on a process of processing the signal slice symbol by the baseband processing circuit, so that a delay in adjusting the gate bias voltage signal based on the control signal can be reduced.

In a possible implementation, a second output end of the baseband processing circuit is coupled to a first input end of the radio frequency processing system. The second output end of the baseband processing circuit is further configured to output a first indication signal. The first indication signal indicates a data volume of valid data carried on the plurality of signal slice symbols. In embodiments of this application, a controller is disposed in the power amplifier. The baseband processing circuit may generate the first indication signal in a process of processing the signal slice symbol. The controller in the power amplifier generates a control signal based on the first indication signal, and outputs the control signal to the gate bias circuit, so as to adjust a voltage value of the gate bias voltage signal.

According to a fourth aspect, embodiments of this application further provide a chip system. The chip system includes at least one processor and at least one interface circuit. The at least one processor and the at least one interface circuit may be interconnected through a line. The processor is configured to support the chip system in implementing the functions or steps described in the second aspect. The at least one interface circuit may be configured to receive a signal from another apparatus (for example, a communication interface, a radio frequency processing system, a baseband processing circuit, a power amplifier, or an antenna), or send a signal to another apparatus (for example, a communication interface, a radio frequency processing system, a baseband processing circuit, a power amplifier, or an antenna). The chip system may include a chip, and may further include another discrete component.

According to a fifth aspect, embodiments of this application further provide a computer-readable storage medium. The computer-readable storage medium includes instructions. When the instructions are run on the processor, the processor is caused to perform the control method described in the second aspect.

For technical principles and beneficial effects of the second aspect, the third aspect, the fourth aspect, and the fifth aspect, refer to related descriptions of the first aspect. Details are not described herein again.

### BRIEF DESCRIPTION OF DRAWINGS

FIG. 1 is a diagram of a structure of a power amplifier;
FIG. 2 is a diagram of an operating range and an amplification gain coefficient of a power amplifier;
FIG. 3 is a first diagram of a structure of a transmitting apparatus according to an embodiment of this application;
FIG. 4 is a diagram of a structure of a radio frequency processing system according to an embodiment of this application;
FIG. 5 is a diagram of a structure of a first power amplifier according to an embodiment of this application;
FIG. 6 is a diagram of efficiency versus a power of the first power amplifier shown in FIG. 5 according to an embodiment of this application;
FIG. 7 is a diagram of a structure of a second power amplifier according to an embodiment of this application;
FIG. 8 is a diagram of efficiency versus a power of the second power amplifier shown in FIG. 7 according to an embodiment of this application;
FIG. 9 is a first diagram of a structure of a third power amplifier according to an embodiment of this application;
FIG. 10 is a second diagram of another structure of a third power amplifier according to an embodiment of this application;
FIG. 11 is a third diagram of yet another structure of a third power amplifier according to an embodiment of this application;
FIG. 12 is a fourth diagram of yet another structure of a third power amplifier according to an embodiment of this application;
FIG. 13 is a fifth diagram of yet another structure of a third power amplifier according to an embodiment of this application;
FIG. 14 is a second diagram of another structure of a transmitting apparatus according to an embodiment of this application;
FIG. 15 is a third diagram of yet another structure of a transmitting apparatus according to an embodiment of this application;
FIG. 16 is a fourth diagram of another structure of a transmitting apparatus according to an embodiment of this application;
FIG. 17 is a schematic flowchart of a control method according to an embodiment of this application;
FIG. 18 is a diagram of a correspondence between a data volume range and a voltage value of a gate bias voltage signal according to an embodiment of this application;
FIG. 19 is a diagram of another correspondence between a data volume range and a voltage value of a gate bias voltage signal according to an embodiment of this application; and
FIG. 20 is a diagram of a structure of a chip system according to an embodiment of this application.

### DESCRIPTION OF EMBODIMENTS

It should be noted that terms such as "first" and "second" in embodiments of this application are merely used to distinguish between features of a same type, and cannot be understood as an indication of relative importance, a quantity, a sequence, or the like.

The term such as "example" or "for example" in embodiments of this application is used to represent giving an example, an illustration, or a description. Any embodiment or design solution described as an "example" or "for example" in this application should not be explained as being more preferred or having more advantages than another embodiment or design solution. To be precise, use of the word such as "example" or "for example" is intended to present a relative concept in a specific manner.

The terms "coupling" and "connection" in embodiments of this application should be understood in a broad sense. For example, the terms may be a physical direct connection, or may be an indirect connection implemented through an electronic component, for example, a connection implemented through a resistor, an inductor, a capacitor, or another electronic component.

First, some basic concepts involved in this application are described.

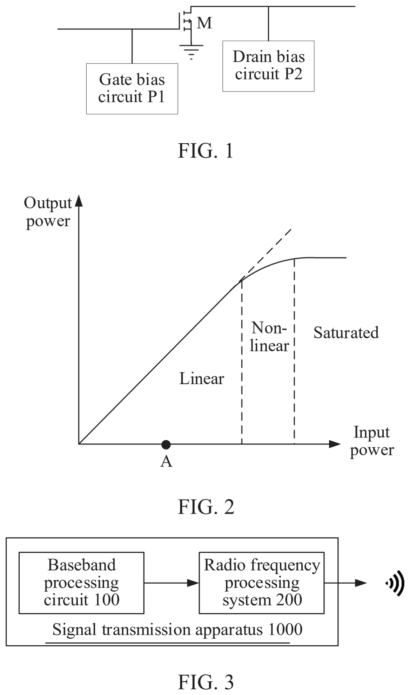

Power amplifier: Power amplifiers may be classified into power transistor-type power amplifiers and switching-type power amplifiers. The power transistor-type power amplifiers may be further classified into class-A power amplifiers, class-B power amplifiers, class-AB power amplifiers, and class-C power amplifiers. The class-A power amplifier, the class-B power amplifier, and the class-AB power amplifier are linear power amplifiers. The class-C power amplifier is a non-linear power amplifier. The class-A power amplifier exhibits optimal linearity and is suitable for power amplification of a small direct current signal. The class-B power amplifier operates in a half-cycle manner. A single-ended class-B power amplifier may produce significant non-linear distortion, and is seldom used for power amplification of a radio frequency signal. Generally, a push-pull structure is formed based on two class-B power amplifiers to produce a positive half cycle and a negative half cycle, and is used for power amplification of an audio signal. The class-AB power amplifier is a combination of the class-A power amplifier and the class-B power amplifier. Efficiency and linearity of the class-AB power amplifier are between efficiency and linearity of the class-A power amplifier and efficiency and linearity of the class-B power amplifier, and the class-AB power amplifier is widely used for power amplification of radio frequency signals. FIG. 1 shows a basic structure of a single power transistor-type power amplifier. In the figure, a gate bias circuit P1 is disposed at a gate of a power transistor M, and a drain bias circuit P2 is disposed at a drain of the power transistor M. The gate bias circuit P1 and the drain bias circuit P2 control bias states of terminals of the power transistor M, so that the power transistor M is in a power amplification state. The power transistor M in the power amplification state may perform power amplification on a received signal.

Efficiency (efficiency) of a power amplifier refers to a percentage of an input power that can be converted into a useful output power. In actual application, a ratio of a signal output power of the power amplifier to a supply power of a power supply is the efficiency of the power amplifier, denoted by η, that is, η = Po/PE×100%. According to the definition, the efficiency of the power amplifier = (output power/supply power)×100%. FIG. 1 is used as an example. Operating efficiency of the power amplifier may be reflected by operating efficiency provided by the drain bias circuit P2 of the power transistor M, namely, a rate at which a drain direct current signal provided by the drain bias circuit P2 is converted into a radio frequency signal actually output by the power amplifier. The operating efficiency of the power amplifier decreases with the decrease of the output power. The output power of the power amplifier is positively correlated with the input power of the power amplifier. The input power of the power amplifier is the power of the radio frequency signal received by the gate of the power transistor M shown in FIG. 1.

Power back-off of the power amplifier: FIG. 2 is a diagram of power amplification of a single power amplifier. It can be seen that the power amplifier has a specific linear operating power range. In the linear operating power range, an amplification gain factor between the input power and the output power of the power amplifier is linear (namely, a proportional constant amplification gain factor). When the input power of the power amplifier exceeds the linear operating power range, the amplification gain factor between the input power and the output power is non-linear. Even when the input power is in a saturation power range of the power amplifier, the output power no longer increases with the increase of the input power. To ensure that the radio frequency signal output by the power amplifier is linearly amplified, power back-off needs to be performed on the power amplifier (that is, a specific amount of power needs to be backed off from a maximum operating power point of power amplification). The radio frequency signal received by the power amplifier is a modulated signal obtained by modulating data information to a carrier signal. A power back-off amount is related to a peak to average power ratio (peak to average power ratio, PAPR) of the modulated signal. In wireless communication, a data signal that needs to be communicated is carried based on the radio frequency signal. A larger data volume carried on the radio frequency signal indicates a higher power of the radio frequency signal received by the power transistor M.

A quiescent current is a current on an electronic component when there is no signal input, i.e., the current consumed by the electronic component without being affected by external factors.

Embodiments of this application provide a signal transmission apparatus. As shown in FIG. 3, the signal transmission apparatus 1000 includes a baseband processing circuit 100 and a radio frequency processing system 200. A first output end of the baseband processing circuit 100 is coupled to a first input end of the radio frequency processing system 200. The baseband processing circuit 100 is configured to: carry data information, in a form of a signal slice symbol, onto a first baseband signal; and send the first baseband signal to the radio frequency processing system 200 by using the first output end of the baseband processing circuit 100. The radio frequency processing system 200 is configured to: generate a radio frequency signal based on the first baseband signal, and transmit the radio frequency signal. The radio frequency signal carries a plurality of signal slice symbols.

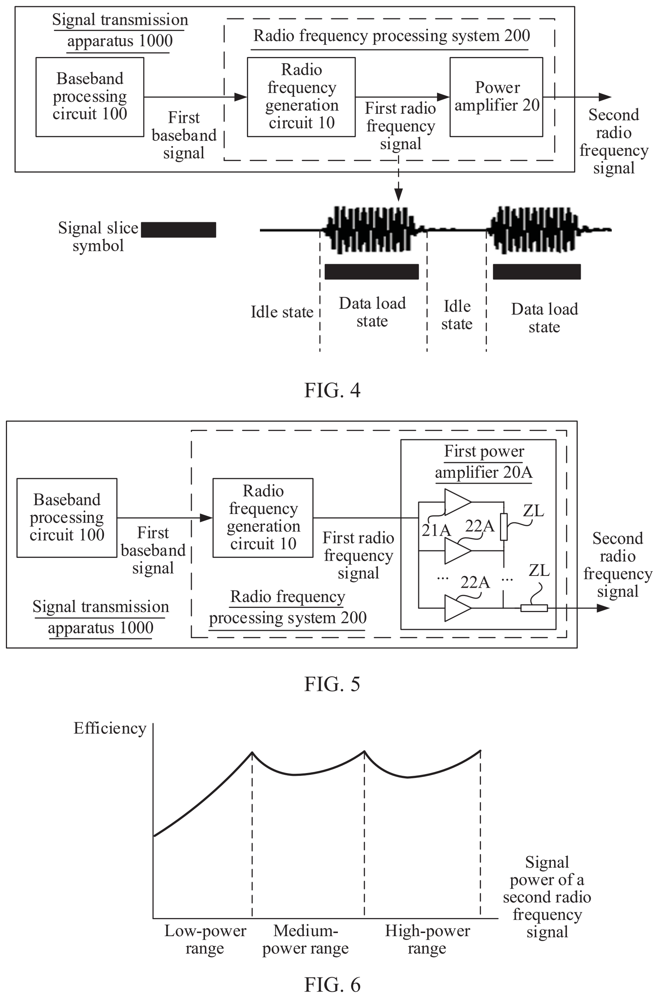

As shown in FIG. 4, the radio frequency processing system 200 includes a radio frequency generation circuit 10 and a power amplifier 20. The radio frequency generation circuit 10 is configured to: generate a first radio frequency signal based on the first baseband signal. The first radio frequency signal carries a plurality of signal slice symbols. The power amplifier 20 is configured to: obtain a second radio frequency signal based on the first radio frequency signal. The second radio frequency signal carries a plurality of signal slice symbols, and there is a gain amplification relationship between a signal power of the second radio frequency signal and a signal power of the first radio frequency signal. In embodiments of this application, the radio frequency generation circuit 10 processes a first baseband signal at a lower frequency, to obtain a first radio frequency signal at a higher frequency. To ensure quality of wireless communication, the power amplifier 20 includes at least one power transistor M, and a second radio frequency signal with a higher signal power is obtained based on the first radio frequency signal by using the at least one power transistor M. The radio frequency processing system 200 transmits the second radio frequency signal to perform wireless communication. In a wireless communication process, a data volume of the first baseband signal is affected by factors such as time, a service scenario, and a current user quantity. The data volume of the first baseband signal varies over time. Similarly, the signal power of the first radio frequency signal varies with the data volume. However, as shown in FIG. 1, the drain bias circuit P2 outputs a constant drain direct current signal (a drain bias voltage signal or a drain bias current signal) to supply power to the power amplifier 20. The power transistor M of the power amplifier 20 generates, based on the signal power of the first radio frequency signal received by the gate and the drain direct current signal serving as a supply power, the second radio frequency signal with a corresponding signal power. In a design of the power amplifier 20, to ensure signal power linearity of the second radio frequency signal, a bandwidth and a back-off amount of the power amplifier 20, and the like, the linear operating range of the power amplifier 20 shown in FIG. 2 needs to be set as wide as possible. Moreover, under data information of most services, the signal power (i.e., the input power in FIG. 2) of the received first radio frequency signal is within a medium-power range or a low-power range of the linear operating range. For example, a data volume of the service data primarily corresponds to a range below a middle point A (i.e., 50% service load) within the linear operating range. In this case, when the power amplifier 20 is in an idle state (that is, the signal slice symbol on the first radio frequency signal carries no valid data, or the power amplifier 20 receives no first radio frequency signal), and when a data volume of the signal slice symbol on the first radio frequency signal is small (for example, less than 50% service load), the at least one power transistor M in the power amplifier 20 has low utilization on the supply power supplied by the drain bias circuit P2, which causes a significant power consumption waste. Power consumption of the power amplifier 20 is a main source of power consumption of the entire radio frequency processing system 200. In addition, with advancement of a wireless technology, a frequency band of the first radio frequency signal and a frequency band of the second radio frequency signal are also increased, and a power consumption problem of the power amplifier 20 is increasingly severe.

To reduce the power consumption of the power amplifier 20, in some possible implementations, the power amplifier 20 shown in FIG. 4 may be a first power amplifier. As shown in FIG. 5, a first power amplifier 20A includes a main amplification circuit 21A and at least one secondary amplification circuit 22A. The main amplification circuit 21A and the at least one secondary amplification circuit 22A form a Doherty (doherty) amplifier through a plurality of impedance transformation lines ZL. The main amplification circuit 21A is a class-AB power amplifier. The at least one secondary amplification circuit 22A is typically a class-C power amplifier. Different quantities of amplification circuits are in conduction based on a signal power level of a received first radio frequency signal, to implement power amplification. Load pull (load pull) is implemented by using the impedance transformation lines ZL, to combine radio frequency signals output by different quantities of amplification circuits, so as to obtain a second radio frequency signal. FIG. 6 is a diagram of a relationship between a power and efficiency of a second radio frequency signal of a first power amplifier 20A. As shown in FIG. 6, an example in which the first power amplifier 20A includes one main amplification circuit 21A and two secondary amplification circuits 22A is used. When a signal power of the first radio frequency signal or a signal power of the second radio frequency signal is within a low-power range of a linear operating range of the first power amplifier 20A, the main amplification circuit 21A of the first power amplifier 20A is in conduction and operates, so as to obtain the second radio frequency signal based on the first radio frequency signal. At a power saturation point in the low-power range, it can be ensured that the first power amplifier 20A has high efficiency, thereby reducing power consumption of the first power amplifier 20A in the low-power range. When the signal power of the first radio frequency signal or the signal power of the second radio frequency signal is within a medium-power range of the linear operating range of the first power amplifier, the main amplification circuit 21A and one secondary amplification circuit 22A of the first power amplifier 20A are in conduction and operate, and both the two amplification circuits obtain a corresponding radio frequency signal based on the first radio frequency signal. When the two amplification circuits are in conduction, as a voltage, a current, and the like of each amplification circuit change, load pull may be implemented by using the impedance transformation lines ZL, so as to obtain the second radio frequency signal through combination. Similarly, at a power saturation point in the medium-power range, it can be ensured that the first power amplifier 20A has high efficiency. When the signal power of the first radio frequency signal and the signal power of the second radio frequency signal are within a high-power range of the linear operating range of the first power amplifier, both the main amplification circuit 21A and the two secondary amplification circuits 22A of the first power amplifier 20A are in conduction. When the three amplification circuits are in conduction, as a voltage, a current, and the like of each amplification circuit change, load pull is also implemented by using the impedance transformation lines ZL, so as to obtain a second radio frequency signal with a high power through combination. At a power saturation point in the high-power range, high efficiency can also be maintained. In embodiments of this application, the first power amplifier 20A is obtained based on a Doherty structure, so that high efficiency can be achieved in different power ranges, to avoid a waste of power consumption. However, to further reduce power consumption in a low-power linear operating range, a quantity of secondary amplification circuits 22A needs to be increased as much as possible. Nevertheless, as the quantity of secondary amplification circuits 22A increases, design complexity, a device area, and device costs of the first power amplifier 20A also increase greatly. In addition, when the quantity of secondary amplification circuits 22A increases excessively (for example, there are more than three secondary amplification circuits 22A), a gain coefficient (i.e., a power amplification ratio of the second radio frequency signal to the first radio frequency signal) of the first power amplifier 20A is also significantly reduced. In conclusion, although the first power amplifier 20A based on the Doherty structure can reduce power consumption in the low-power range to some extent, extent to which the power consumption in the low-power range is reduced is limited, and the solution is difficult and complex to implement.

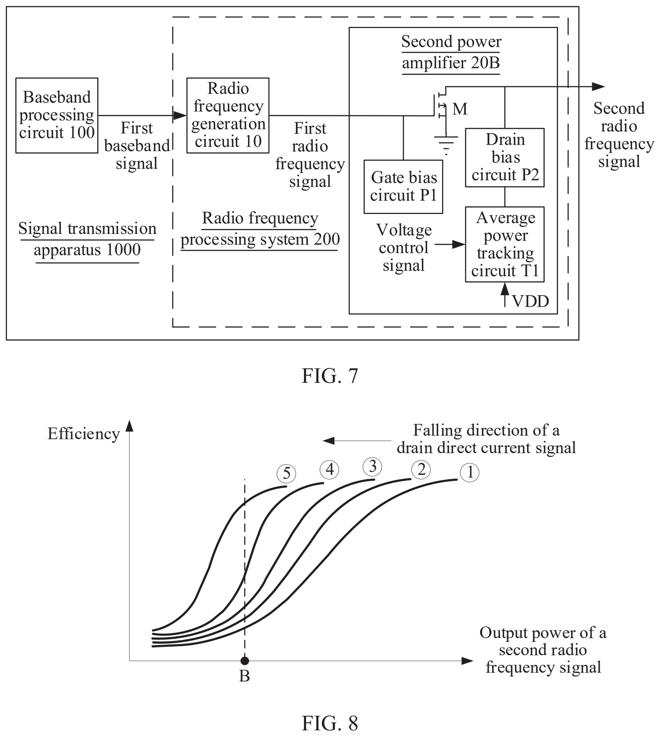

In some possible implementations, the power amplifier 20 shown in FIG. 4 may be a second power amplifier. As shown in FIG. 7, a second power amplifier 20B includes at least one power transistor M, a gate bias circuit P1, a drain bias circuit P2, and an average power tracking circuit (avarage power tracking) circuit T1. An output end of the gate bias circuit P1 is coupled to a gate of the at least one power transistor M. An output end of the average power tracking circuit T1 is coupled to an input end of the drain bias circuit P2. An output end of the drain bias circuit P2 is coupled to a drain of the at least one power transistor M. For example, as shown in FIG. 7, a VDD comes from an external power supply of the second power amplifier 20B or a secondary power supply (that is, a power supply that converts an external supply power inside the second power amplifier 20B) in the second power amplifier 20B. The average power tracking circuit T1 controls, based on a magnitude of an average output power of the second radio frequency signal that is output by the second power amplifier 20B, a magnitude of a voltage that is output to the input end of the drain bias circuit P2. In some examples, a detection feedback circuit may be coupled to an output end of the second power amplifier 20B, the average output power of the second radio frequency signal is obtained by using the detection feedback circuit, and a voltage control signal is generated and sent to the average power tracking circuit T1. The average power tracking circuit T1 controls a magnitude of a drain direct current signal output by the drain bias circuit P2. In embodiments of this application, as shown in FIG. 8, a curve 1, a curve 2, a curve 3, a curve 4, and a curve 5 are diagrams showing a relationship between a signal power of the second radio frequency signal and efficiency of the second power amplifier 20B under a plurality of drain direct current signals arranged in a descending order. It can be seen from FIG. 8 that when the signal power of the second radio frequency signal is at a signal power point B, as the drain direct current signal decreases, the efficiency of the second power amplifier 20B increases, and thus an objective of reducing power consumption is achieved. However, in the embodiment shown in FIG. 7, an equivalent capacitance exists at a power supply interface of the second power amplifier 20B, thereby presenting a capacitive load. In a power supply process, the equivalent capacitance presents charging, discharging, or other characteristics, which affects a response speed of power supply. Therefore, in a process of controlling a gate direct current signal based on the average power tracking circuit T1, under the limitation of a response speed in adjusting the VDD voltage, the average power tracking circuit T1 can only perform feedback adjustment at a low speed, and precise and rapid average power tracking is difficult to achieve.

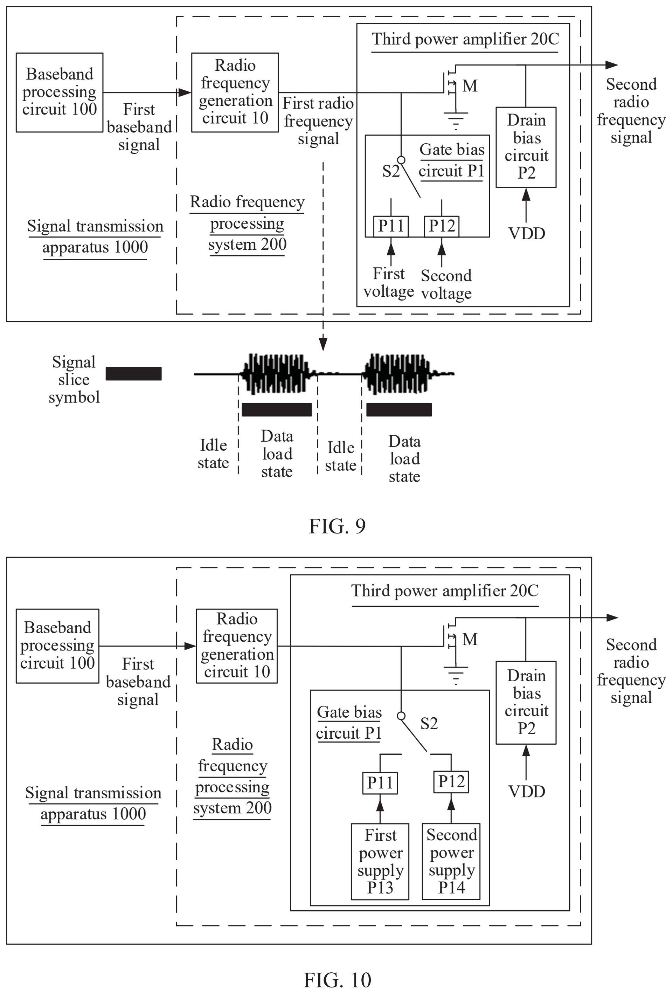

In some possible implementations, the power amplifier 20 shown in FIG. 4 may be a third power amplifier. As shown in FIG. 9, a third power amplifier 20C includes a gate bias circuit P1, a drain bias circuit P2, and at least one power transistor M. The drain bias circuit P2 is coupled to a drain of the at least one power transistor M. The gate bias circuit P1 includes a first power supply interface P11 and a second power supply interface P12. A first voltage signal received by the first power supply interface P11 is greater than a second voltage signal received by the second power supply interface P12. A gate of the at least one power transistor M is configured to receive a first radio frequency signal, and the first radio frequency signal carries a plurality of signal slice symbols. When a first signal slice symbol carries valid data, the gate of the at least one power transistor M is coupled to the first power supply interface P11. When the first signal slice symbol carries no valid data or no first radio frequency signal is received, the gate of the at least one power transistor M is coupled to an output end of the second power supply interface P12.

For example, as shown in FIG. 9, in wireless communication application, a baseband processing circuit 100 slices, based on at least one of factors such as a user quantity, a volume of service interaction data, and a used network protocol, interaction data of wireless communication, and generates a first baseband signal that carries the signal slice symbol. A radio frequency generation circuit 10 performs modulation based on the first baseband signal to obtain the first radio frequency signal. The first radio frequency signal also carries the plurality of signal slice symbols. A data volume on each signal slice symbol may be the same or may be different. In addition, based on different modulation manners, when the first baseband signal does not have the signal slice symbol, the radio frequency generation circuit 10 may not output the first radio frequency signal. For example, in a process of modulating the first baseband signal to the first radio frequency signal in an amplitude shift keying (amplitude shift keying, ASK) modulation manner, when the baseband processing circuit 100 does not output the first baseband signal that carries the signal slice symbol, the radio frequency generation circuit 10 may output a radio frequency signal with a signal amplitude of 0 (i.e., no first radio frequency signal is output). When the first signal slice symbol carries no valid data, or the third power amplifier 20C receives no first radio frequency signal, the third power amplifier 20C does not need to perform actual power amplification, and this state may be referred to as an idle (idle) state of the third power amplifier 20C. When the third power amplifier 20C is in the idle state, a current flowing through the drain of the at least one power transistor M is a static bias current. A larger static bias current of the drain of the power transistor M indicates higher power consumption of the third power amplifier 20C. Power consumption of the third power amplifier 20C in the idle state is the highest. However, in a process of performing power amplification on the first radio frequency signal, in the conventional technology, precise management cannot be implemented on a short-period idle state that occurs in an interval between the plurality of signal slice symbols. In embodiments of this application, the first power supply interface P11 and the second power supply interface P12 are disposed in the gate bias circuit P1. The first voltage signal is received by using the first power supply interface P11. The second voltage signal is received by using the second power supply interface P12. The first voltage signal is greater than the second voltage signal. When the first signal slice symbol carries the valid data, it indicates that the third power amplifier 20C needs to perform normal power amplification operation, and couples the gate of the at least one power transistor M to the output end of the first power supply interface P11 to be in conduction, so as to receive the first voltage signal. When the first signal slice symbol carries no valid data or no first radio frequency signal is received, the third power amplifier 20C is in the idle state, and couples the gate of the at least one power transistor M to the output end of the second power supply interface P12 to be in conduction.

In some examples, the at least one power transistor M may be an enhanced transistor or a depleted transistor. In addition, the enhanced transistor or the depleted transistor may be a P-metal-oxide-semiconductor (P-metal-oxide-semiconductor, PMOS) transistor or an N-metal-oxide-semiconductor (N-metal-oxide-semiconductor, NMOS) transistor respectively. In some possible examples, the at least one power transistor M may be classified into a voltage-controlled voltage-type amplification power transistor or a voltage-controlled current-type amplification power transistor based on different control types of the at least one power transistor M. The voltage-controlled voltage-type amplification power transistor refers to a power transistor M in which a voltage between a drain and a source of the power transistor M is controlled based on a voltage of a gate. The voltage-controlled current-type power transistor refers to a power transistor M in which a current between a drain and a source of the power transistor M is controlled based on a voltage of a gate. In some examples, the at least one power transistor M may be based on a GaN (GaN) material, a GaAS (GaAS) material, a Si (Si)-based material, or the like. In some examples, based on an actual transistor type (for example, a P-type enhanced transistor, a P-type depleted transistor, an N-type enhanced transistor, and an N-type depleted transistor) of the at least one power transistor M, the first voltage signal and the second voltage signal may be positive voltages, or may be negative voltages. In addition, the first voltage signal may be greater than the second voltage signal, or the first voltage signal is less than the second voltage signal.

An example in which the at least one power transistor M is a GaN-based P-type depleted transistor is used. When the gate of the at least one power transistor M receives a negative voltage, a channel between the drain and the source of the power transistor M is conducted. A larger negative voltage (that is, the closer the negative voltage is to a zero voltage) indicates a larger conduction width of the channel between the drain and the source of the power transistor M, so that the current (or voltage) between the drain and the source is larger. In this case, the first voltage signal corresponding to the data load state is greater than the second voltage signal corresponding to the idle state. An example in which the at least one power transistor M is an N-type enhanced transistor based on a Si material or a GaN material is used. When the gate of the at least one power transistor M receives a positive voltage, a channel between the drain and the source of the power transistor M is conducted. A larger positive voltage (that is, the more the positive voltage exceeds a zero voltage) indicates a larger conduction width of the channel between the drain and the source of the power transistor M, so that the current (or voltage) between the drain and the source is larger. In this case, the first voltage signal corresponding to the data load state is greater than the second voltage signal corresponding to the idle state.

In embodiments of this application, a specific voltage difference exists between the first voltage signal and the second voltage signal. When the third power amplifier 20C is in the idle state, the second voltage signal is used as a gate bias voltage signal of the at least one power transistor M, to reduce a conduction width of the channel between the drain and the source of the power transistor M, thereby further reducing a static bias direct current signal of the power transistor M and reducing power consumption in the idle state. The static bias direct current signal may be a static bias current signal or a static bias voltage signal. When the third power amplifier 20C is in the data load state, the first voltage signal is used as the gate bias voltage signal of the at least one power transistor M to increase the conduction width of the channel between the drain and the source of the power transistor M, thereby further increasing an operating bias direct current signal of the power transistor M to meet a requirement for normal power amplification.

For example, as shown in FIG. 9, the third power amplifier 20C further includes a second gating switch S2. The gate of the at least one power transistor M is coupled, via the second gating switch S2, to an output end of the first power supply interface P11 or to an output end of the second power supply interface P12.

In some possible implementations, the first voltage signal and the second voltage signal are external voltages received by the third power amplifier 20C. In this case, the first power supply interface P11 is coupled to an external power supply of the third power amplifier 20C, to receive the first voltage signal; and/or the second power supply interface P12 is coupled to an external power supply of the third power amplifier 20C, to receive the second voltage signal.

In some possible implementations, the first voltage signal and the second voltage signal are secondary power supplies generated inside the third power amplifier 20C. In this case, as shown in FIG. 10, the gate bias circuit P1 further includes a first power supply P13 and a second power supply P14. An output end of the first power supply P13 is coupled to an input end of the first power supply interface P11. The first power supply P13 is configured to output a first voltage signal. An output end of the second power supply P14 is coupled to an input end of the second power supply interface P12. In some examples, the first power supply P13 and the second power supply P14 may be a digital-to-analog converter (digital-to-analog converter, DAC). A first voltage signal and a second voltage signal, which are a positive voltage or a negative voltage, are generated by the DAC. In some examples, the first power supply P13 and the second power supply P14 may alternatively be a charge pump voltage conversion circuit, a voltage source, a low dropout regulator (low dropout regulator, LDO), or the like.

In some possible implementations, when the third power amplifier 20C is in the data load state, a voltage value of the first voltage signal may be further adjusted based on a current data volume of a first signal slice symbol, so as to reduce power consumption of the third power amplifier 20C in the data load state. In this case, the gate bias circuit P1 further includes a voltage adjusting circuit. The voltage adjusting circuit is configured to: when the first signal slice symbol carries valid data, adjust a magnitude of the first voltage signal to a first voltage value, where the first voltage value corresponds to a data volume range within which the valid data carried on the first signal slice symbol is.

In embodiments of this application, a plurality of data volume ranges may be divided based on the data volume of the signal slice symbol in the data load state, and the first voltage signal with a corresponding voltage value is set for each data volume range. The first voltage signal corresponding to a larger data volume range may cause a larger conduction width of the channel between the drain and the source of the power transistor M, and the increase of the conduction width of the channel results in a large drain direct current signal, to meet a requirement for power amplification under a larger data volume.

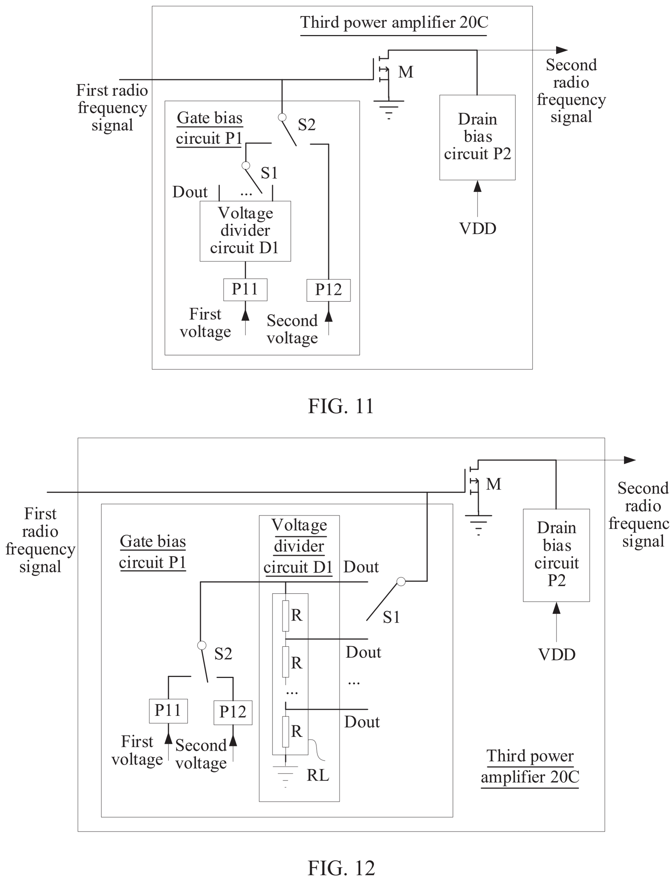

In a possible implementation, a voltage output by the first power supply interface may be adjusted to obtain the first voltage signals of different voltage magnitudes. As shown in FIG. 11 and FIG. 12, the voltage adjusting circuit is a voltage divider circuit D1. The voltage divider circuit D1 includes a plurality of voltage divider output ends Dout. The plurality of voltage divider output ends Dout are in one-to-one correspondence with the plurality of data volume ranges. When the first signal slice symbol carries valid data and a data volume of the valid data is within a first data volume range, an input end of the voltage divider circuit D1 is coupled to the first power supply interface P11, and the gate of the at least one power transistor M is in conduction with a first voltage divider output end. The first voltage divider output end is a voltage divider output end Dout corresponding to the first data volume range. In some examples, as shown in FIG. 11, the voltage divider circuit D1 may be coupled between the second gating switch S2 and the output end of the first power supply interface P12. In some examples, as shown in FIG. 12, the voltage divider circuit D1 may be coupled to a subsequent stage of the second gating switch S2. In embodiments of this application, the gate bias voltage signal of the power transistor M is adjusted at a signal slice symbol level, so that efficiency of the third power amplifier 20C is dynamically improved as much as possible while normal power amplification of the third power amplifier 20C is maintained, and power consumption caused by the drain direct current signal is reduced.

For example, as shown in FIG. 12, the voltage divider circuit D1 includes a resistor ladder RL. The resistor ladder RL includes a plurality of equivalent resistors R. The plurality of equivalent resistors R are connected in series. A first end of the resistor ladder RL is an input end of the voltage divider circuit D1. A second end of the resistor ladder RL is grounded. The plurality of equivalent resistors R are coupled to the plurality of voltage divider output ends Dout respectively. A plurality of different voltage values may be obtained through voltage division by connecting the plurality of equivalent resistors R in series. The voltage divider output ends Dout may be coupled to a first end or a second end of the equivalent resistor R. Each voltage value may correspond to one data volume range.

For example, each equivalent resistor R may include one or more resistors. When the equivalent resistor R includes a plurality of resistors, the plurality of resistors may be connected in series and/or in parallel.

For example, in embodiments in which the first voltage signal is greater than the second voltage signal, a larger voltage value of the first voltage signal indicates a larger conduction width of the channel between the drain and the source of the power transistor M. In this case, a voltage divider output end Dout that is closer to the first end (i.e., the output end of the first power supply interface P11) of the resistor ladder RL corresponds to a larger data volume range. A voltage divider output end Dout that is closer to the second end (that is, the ground end) of the resistor ladder RL corresponds to a smaller data volume range.

For example, in embodiments in which the first voltage signal is less than the second voltage signal, a smaller first voltage signal indicates a larger conduction width of the channel between the drain and the source of the power transistor M. In this case, the voltage divider output end Dout that is closer to the first end (that is, the output end of the first power supply interface P11) of the resistor ladder RL corresponds to a smaller data volume range. The voltage divider output end Dout that is closer to the second end (that is, the ground end) of the resistor ladder RL corresponds to a larger data volume range.

In embodiments of this application, when the data volume of the first signal slice symbol is a preset maximum data volume, the first voltage signal corresponding to the maximum data volume range is selected as the gate bias voltage signal, so as to ensure a requirement for power amplification. Similarly, if the data volume of the first signal slice symbol is smaller, the first voltage signal corresponding to the smaller data volume range is correspondingly selected as the gate bias voltage signal, so as to reduce the conduction width of the channel between the drain and the source of the power transistor M and dynamically reduce the power consumption of the third power amplifier 20C in real time.

In some possible implementations, as shown in FIG. 12, the third power amplifier 20C further includes a first gating switch S1. The plurality of voltage divider output ends Dout are coupled to the gate of the at least one power transistor M via the first gating switch S1. The selection, switching, and the like of the first voltage signals with different voltage values may be performed via the first gating switch S1.

In some possible implementations, when the first signal slice symbol carries no valid data or no first radio frequency signal is received, the first gating switch S1 is directly connected to the output end of the second power supply interface P12. In embodiments of this application, as shown in FIG. 12, when the first signal slice symbol carries no valid data or no first radio frequency signal is received, the third power amplifier 20C is in the idle state. In this case, the gate of the power transistor M needs to receive the second voltage signal. However, the voltage divider circuit D is coupled between the output end of the second power supply interface P12 and the gate of the power transistor M. If the voltage divider circuit D performs voltage division on the second voltage signal, a voltage of a subsequent stage of the voltage divider circuit D is elevated, which affects the power transistor M. In addition, more bottom noise may be generated on a generated second radio frequency signal, and data accuracy of the second radio frequency signal is affected. Therefore, when the third power amplifier 20C is in the idle state, the first gating switch S1 may be turned on to be in conduction with the voltage divider output end Dout corresponding to the first end of the resistor ladder RL, so as to be directly connected to the output end of the second power supply interface P12.

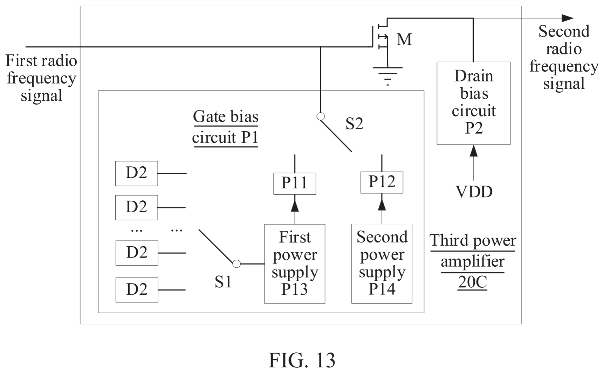

In some possible implementations, a magnitude of the first voltage signal received by the input end of the first power supply interface may be adjusted to generate first voltage signals of different voltage magnitudes. As shown in FIG. 13, the voltage adjusting circuit includes a plurality of reference power supplies D2. A plurality of reference output ends corresponding to the plurality of reference power supplies D2 are configured to output a plurality of reference voltages. The plurality of reference voltages have different voltage values, and the plurality of reference voltages correspond to a plurality of data volume ranges. When the first signal slice symbol carries the valid data and a data volume of the valid data is within a first data volume range, a voltage input end of the first power supply is coupled to a first reference output end. The first reference output end is the reference output end corresponding to the first data volume range. In embodiments of this application, the plurality of reference power supplies D2 may output reference voltages with different voltage values, and each reference power supply D2 corresponds to a respective data volume range of the signal slice symbol. The reference voltages with different voltage values are output to the first power supply P13 and used as operating voltages of the first power supply P13. Driven by different operating voltages, the first power supply P13 may output the first voltage signals with different voltage values.

An example in which the first power supply P13 is a DAC is used. Under operating voltages with different values, the first power supply may obtain the first voltage signals with different voltage values through conversion. For example, as shown in FIG. 13, different reference power supplies D2 may be selected and switched via the first gating switch S1. For example, the reference power supply D2 may be a digital register.

For a correspondence between the first voltage signal and the data volume range in the embodiment shown in FIG. 13, refer to related descriptions in the embodiment shown in FIG. 12. Details are not described herein again.

In some possible implementations, a signal transmission apparatus 1000 further includes a controller. The controller implements selection and switching between the first voltage signal and the second voltage signal in the data load state and in the idle state in the embodiments in FIG. 9 and FIG. 10. Further, the controller may implement operations of adjusting the voltage value of the first voltage signal in the data load state in the embodiments in FIG. 11, FIG. 12, and FIG. 13.

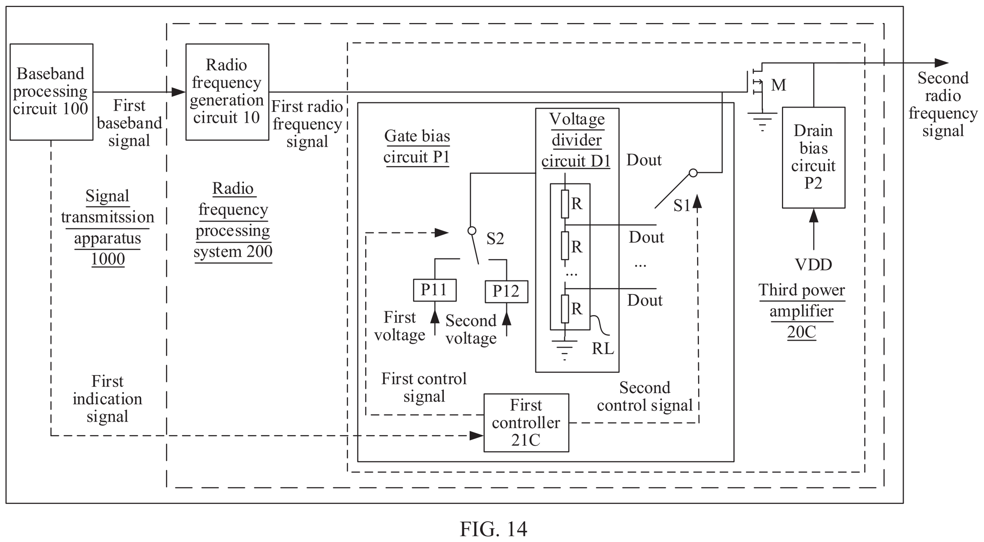

In some examples, the controller may be a first controller disposed in the third power amplifier 20C. As shown in FIG. 14, the third power amplifier 20C includes a first controller 21C. A second output end of the baseband processing circuit 100 is coupled to an input end of the first controller 21C. An output end of the first controller 21C is coupled to a controlled end of the gate bias circuit P1. The baseband processing circuit 100 outputs a first indication signal to the first controller 21C. The first indication signal indicates a data volume of valid data carried on the plurality of signal slice symbols. The first controller 21C sends a control signal to the gate bias circuit P1 based on the first indication signal, so as to implement selection and switching between the first voltage signal and the second voltage signal, and adjust the voltage value of the first voltage signal.

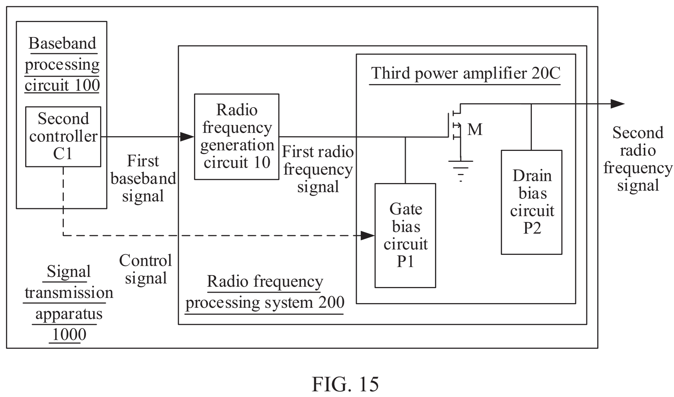

In some examples, the controller may be a second controller disposed in the baseband processing circuit 100. As shown in FIG. 15, a second controller C1 sends a control signal to the gate bias circuit P1 of the third power amplifier 20C, so as to implement selection and switching between the first voltage signal and the second voltage signal, and adjust the voltage value of the first voltage signal.

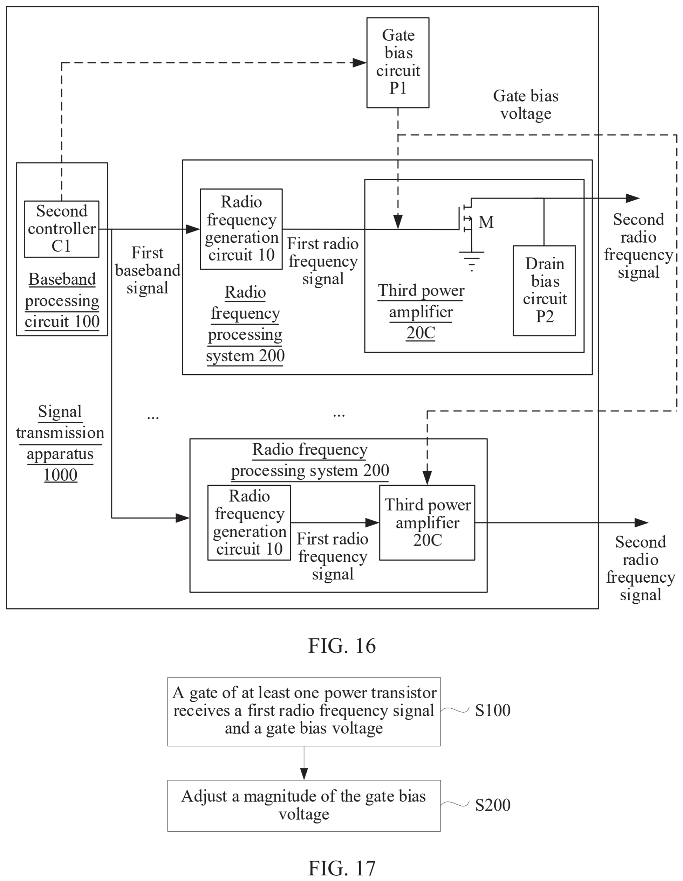

In some possible implementations, the signal transmission apparatus 1000 may include a plurality of radio frequency processing systems 200. The plurality of radio frequency processing systems 200 may receive a same first radio frequency signal, or may receive different first radio frequency signals. In some examples, when the plurality of radio frequency processing systems 200 receive the same first radio frequency signal, the plurality of radio frequency processing systems 200 may implement power amplification based on an independent gate bias circuit P1. In some examples, as shown in FIG. 16, a same gate bias circuit P1 may be shared between the plurality of radio frequency processing systems 200. Similarly, when the radio frequency processing system 200 includes the second controller C1 shown in FIG. 15, the plurality of radio frequency processing systems 200 may also share the same second controller C1.

In some possible implementations, a type of the third power amplifier 20C composed of the at least one power transistor M is not limited in embodiments of this application. For example, the third power amplifier 20C may be a class-AB power amplifier, a power amplifier based on a Doherty architecture, a power amplifier based on a Chireix architecture, a power amplifier based on out phasing (out phasing) modulation, a sequential (sequential) power amplifier, a power amplifier based on an envelope tracking technology, or the like.

In some possible implementations, the baseband processing circuit 100 may be a baseband unit (baseband unit, BBU). The radio frequency processing system 200 may be a remote radio unit (remote radio unit, RRU), an active antenna unit (active antenna unit, AAU), or the like.

In some possible implementations, the signal transmission apparatus 1000 may be a base station (base station), a terminal device, a mobile phone, a notebook computer, a tablet computer, a smartwatch, a smart home appliance, a smart car, or the like.

Based on the structures shown in FIG. 9, FIG. 10, FIG. 11, FIG. 12, FIG. 13, FIG. 14, FIG. 15, and FIG. 16, a control method shown in FIG. 17 including the following step S100 and step S200 may be implemented.

S100: A gate of at least one power transistor M receives a first radio frequency signal and a gate bias voltage signal.

For example, a transistor may be used as a switch and the power transistor M. When the transistor needs to be used as the power transistor M, as shown in FIG. 1, a gate direct current signal needs to be disposed at the gate of the power transistor M, and a drain direct current signal needs to be disposed at a drain of the power transistor M. The transistor is controlled to be biased in an amplification state by using a gate bias direct current signal and a drain bias direct current signal, so as to serve as the power transistor M. Generally, the power transistor M is a voltage-controlled voltage-type or voltage-controlled current-type transistor. The gate direct current signal may be the gate bias voltage signal. When the power transistor M performs power amplification, the gate of the power transistor M receives the first radio frequency signal. The power transistor M operating in the amplification state outputs, from the drain based on the first radio frequency signal and the drain direct current signal, a second radio frequency signal that has a gain amplification relationship with the first radio frequency signal, so as to complete power amplification, and output the second radio frequency signal.

S200: Adjust a magnitude of the gate bias voltage signal.

For example, the magnitude of the gate bias voltage signal is adjusted based on a data volume of valid data carried on a signal slice symbol. For example, when the data volume of the valid data is zero, it indicates that the signal slice symbol carries no valid data, or no first radio frequency signal is received. In this case, a third power amplifier 20C is in an idle state, and a second voltage signal corresponding to the idle state may be used as the gate bias voltage signal. The second voltage signal enables a channel of the power transistor M to have a small conduction width, to reduce a current or a voltage between the drain and a source and reduce power consumption. When the signal slice symbol carries the valid data, the third power amplifier 20C is in a data load state, and a first voltage signal corresponding to the data load state may be used as the gate bias voltage signal. The first voltage signal enables the channel of the power transistor M to have a large conduction width, to increase a current or a voltage between the drain and the source and maintain normal power amplification in the data load state.

In some possible implementations, step S200 may include sub-operations of the following step S210 and step S220.

S210: Generate a control signal.

In some possible implementations, as shown in FIG. 14, a baseband processing circuit 100 generates a first indication signal based on a data volume of a first signal symbol carried on a first baseband signal that needs to be sent. The first indication signal indicates the data volume of the valid data carried on a plurality of signal slice symbols. After receiving the first indication signal, a first controller 21C of the third power amplifier 20C in a radio frequency processing system 200 generates a related control signal based on the first indication signal, and sends the control signal to a gate bias circuit P1.

In some possible implementations, as shown in FIG. 15, a second controller C1 in the baseband processing circuit 100 generates a control signal based on the data volume of the first signal symbol carried on the first baseband signal that needs to be sent, and outputs the control signal to the gate bias circuit P1 of the third power amplifier 20C in the radio frequency processing system 200. In embodiments of this application, before the baseband processing circuit 100 outputs the first baseband signal, the second controller C1 in the baseband processing circuit 100 performs a correlation processing operation and the like on the processed signal slice symbol in advance. The second controller C1 can process the signal slice symbol in the baseband processing circuit 100, generate the control signal, and output the control signal to the gate bias circuit P1 of the third power amplifier 20C. The second controller C1 may be an existing related control device in the baseband processing circuit 100. According to the solutions recorded in embodiments of this application, no additional control device needs to be disposed, so that device costs can be reduced. In addition, when the second controller C1 processes and generates a second baseband signal, a related control signal may be generated and sent to the gate bias circuit P1, so that the gate bias voltage signal can be adjusted quickly, promptly, and accurately, thereby implementing precise power consumption control on the third power amplifier 20C at a signal slice symbol level.

S220: Adjust the gate bias voltage signal based on the control signal.

In some examples, power consumption of the third power amplifier 20C in the idle state may be reduced by using the control signal. As shown in FIG. 14, the control signal includes a first control signal. A second gating switch S2 is controlled, based on the first control signal, to perform selection and switching between the first voltage signal and the second voltage signal. A specific voltage difference exists between the first voltage signal and the second voltage signal. When the first signal slice symbol on the first radio frequency signal received by the gate of the power transistor M carries the valid data, it indicates that the third power amplifier 20C is in the data load state, and the first voltage signal enables the channel between the drain and the source of the power transistor M to have a large conduction width, so as to ensure normal power amplification. When the first signal slice symbol on the first radio frequency signal received by the gate of the power transistor M does not have the valid data, or the power transistor M receives no first radio frequency signal, it indicates that the third power amplifier 20C is in the idle state, and the second voltage signal enables the channel between the drain and the source of the power transistor M to have a small conduction width, so as to reduce the drain direct current signal of the power transistor M, and reduce power consumption of the third power amplifier 20C. In embodiments of this application, a gating state of the second gating switch S2 may be controlled by using the first control signal, to implement precise control on the gate bias voltage signal at a signal slice symbol level, thereby reducing power consumption of the third power amplifier 20C in the idle state as much as possible.

In some examples, power consumption of the third power amplifier 20C in the data load state may be reduced by using the control signal. As shown in FIG. 11, FIG. 12, and FIG. 13, when the gate bias circuit P1 is controlled to output the first voltage signal to the power transistor M, a magnitude of the output first voltage signal is further controlled to be a first voltage value. The first voltage value corresponds to a data volume range within which the valid data carried on the first signal slice symbol is.

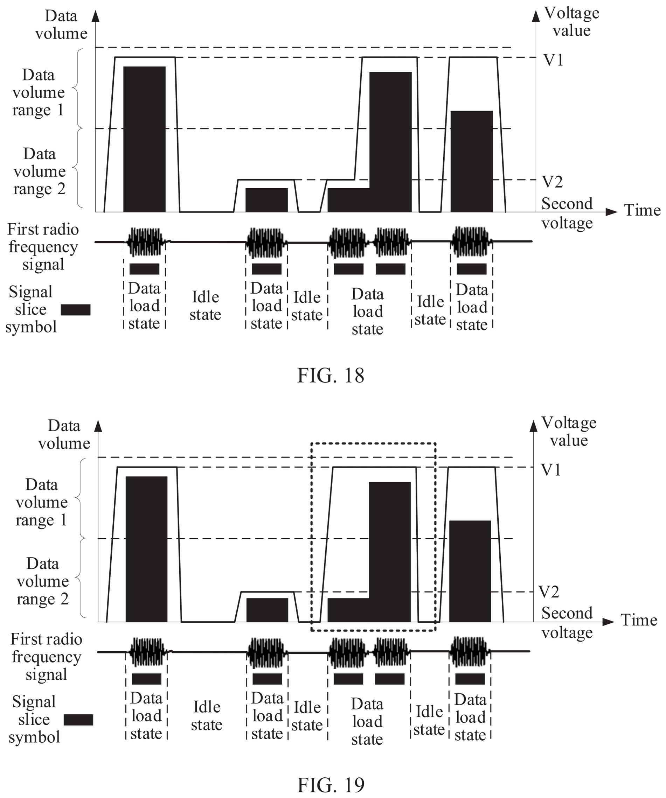

For example, the data volume of the signal slice symbol may be within different data volume ranges, and different data volume ranges correspond to different signal powers of the first radio frequency signal. Under different signal powers, the conduction width of the channel between the drain and the source of the power transistor M may be correspondingly adjusted, so as to reduce power consumption while maintaining normal operation of power amplification. Therefore, for different data volume ranges, a first voltage signal with a corresponding voltage value may be set. In actual application, the conduction width of the channel between the drain and the source of the power transistor M may be controlled based on the data volume range within which the data volume of the first signal slice symbol is and the first voltage signal with the corresponding voltage value (for example, the first voltage value). As shown in FIG. 18, when the data volume of the signal slice symbol is within a high data volume range, the first voltage signal with the corresponding voltage value of V1 is used as the gate bias voltage signal. In the idle state, the second voltage signal is used as the gate bias voltage signal. When the data volume of the signal slice symbol is within a low data volume range, the first voltage signal with the corresponding voltage value of V2 is used as the gate bias voltage signal.

In some examples, when data volumes carried on a plurality of adjacent signal slice symbols are within at least two data volume ranges, the voltage value of the first voltage signal is set to a voltage value corresponding to a second data volume range. The second data volume range is a highest data volume range in the at least two data volume ranges. For example, as shown in FIG. 19, for the plurality of adjacent signal slice symbols (for example, two signal slice symbols shown in a dashed box in the figure), when the plurality of signal slice symbols are within the at least two data volume ranges, it indicates that a switching operation of the voltage value of the first voltage signal is performed at least once in a process of performing power amplification on the first radio frequency signal corresponding to the plurality of adjacent signal slice symbols. In some application scenarios, a specific switching time is required for switching selection between different voltage values. In a scenario that has a specific requirement for transmission precision, switching may not be performed between the plurality of (for example, two or three) adjacent signal slice symbols, and a voltage value corresponding to a highest data volume range of the plurality of adjacent signal slice symbols is used as the voltage value of the first voltage signal.

For example, the control signal further includes a second control signal. A magnitude of the first voltage signal is controlled based on the second control signal. For example, as shown in FIG. 12, a first gating switch S1 is turned on, based on the second control signal, to be in conduction with a corresponding voltage divider output end Dout, so as to obtain the first voltage signal corresponding to the data volume range within which the data on the first signal slice symbol is. For example, as shown in FIG. 13, the first gating switch S1 is turned on, based on the second control signal, to be in conduction with a corresponding reference output end, so as to obtain a reference voltage corresponding to the data volume range within which the data on the first signal slice symbol is. A first power supply P13 outputs the first voltage signal with the corresponding voltage value by using the corresponding reference voltage.

For example, as shown in FIG. 12, when the third power amplifier 20C is in the idle state, the second gating switch S2 is controlled, by using the first control signal, to be coupled to and in conduction with an output end of the second power supply interface P12. To avoid a problem that the voltage divider circuit D performs voltage division on the second voltage signal that is output by the second power supply interface P12, and consequently a voltage of a subsequent stage of the voltage divider circuit D is elevated, in some examples, parameters may be configured for the first gating switch S1, so that the first gating switch S1 keeps coupled to an input end of the voltage divider circuit D (that is, directly connected to the output end of the second power supply interface P12) when no second control signal is input. In some examples, alternatively, when the third power amplifier 20C is in the idle state, the first gating switch S1 may be controlled, by using the second control signal, to be coupled to the input end of the voltage divider circuit D.

For example, as shown in FIG. 12, when the power transistor is a depleted transistor based on a GaN material, an example in which a voltage output by the first power supply P13 is - 2.8 V, and a voltage output by the second power supply P14 is -10 V is used. When a signal power of the first radio frequency signal is 0 (that is, when the first signal slice symbol carries no valid data, or no first radio frequency signal is received actually), the second gating switch S2 is controlled, by using the first control signal, to be coupled to and in conduction with the second power supply interface P12. In a case in which the first gating switch S1 is directly connected to the second power supply interface P12, the gate bias voltage signal of the power transistor M is the second voltage signal (-10 V). In this case, a static bias current corresponding to the drain of the power transistor M is 30 mA. The third power amplifier 20C is in a low power consumption state. When the valid data carried on the first signal slice symbol is within the highest data volume range, the second gating switch S2 is controlled, by using the first control signal, to be coupled to and in conduction with the first power supply interface P12. The first gating switch S1 is controlled, by using the second control signal, to be coupled to a corresponding voltage divider output end Dout (for example, the input end of the voltage divider circuit D) based on the highest data volume range within which a data volume of the valid data on the first signal slice symbol is. After a voltage of 2.8 V passes through the voltage divider circuit D, a first voltage signal of 2.7 V is obtained. Under the first voltage signal of 2.7 V, the static bias current corresponding to the drain of the power transistor M is 50 mA. An example in which the drain direct current signal is a drain bias voltage signal of 34 V is used. Under a low power consumption state corresponding to the idle state, the power consumption of the third power amplifier 20C is 32.64 W, and under a full-load and high power consumption state with the first voltage signal of 2.7 V, corresponding power consumption is 54.4 W. According to embodiments of this application, in a case of the idle state with low power consumption, compared with a conventional solution, power consumption of 21.76 W can be reduced. In addition, in a case in which the data of the signal slice symbol is not within the highest data volume range, the value of the first voltage signal may be further adjusted, so that power consumption can still be reduced to some extent in the data load state.

Embodiments of this application provide a power amplifier, a control method, a radio frequency processing system, and a signal transmission apparatus. The power amplifier includes a gate bias circuit, a drain bias circuit, and at least one power transistor. The gate bias circuit outputs a gate bias voltage signal to a gate of the power transistor. A drain bias circuit outputs a drain direct current signal to a drain of the power transistor. The drain direct current signal may be a drain bias voltage signal or a drain bias current signal. The power transistor M is biased in an amplification state by using the gate bias voltage signal and the drain direct current signal. In addition, after receiving a first radio frequency signal, the power transistor M generates a second radio frequency signal of a corresponding power based on a conduction degree of a channel between a drain and a source of the power transistor M. The first radio frequency signal carries a plurality of signal slice symbols. A power of the first radio frequency signal is positively correlated with a data volume of the signal slice symbol. When the data volume of the signal slice symbol is small or no first radio frequency signal is received, energy conversion efficiency of the power transistor is low, causing a significant power consumption waste. Therefore, in embodiments of this application, a magnitude of the gate bias voltage signal of the power transistor is adjusted based on the data volume of the signal slice symbol carried on the first radio frequency signal. By adjusting the magnitude of the gate bias voltage signal, a waste of power consumption of the power transistor is reduced and a requirement for normal operation of power amplification of the power transistor is met. In embodiments of this application, the gate bias voltage signal is adjusted based on precision of a signal slice symbol level, so that adjustment precision is high, timeliness is good, and reduction in power consumption is high.

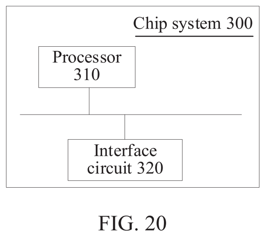

Embodiments of this application further provide a chip system. As shown in FIG. 20, a chip system 300 includes at least one processor 310 and at least one interface circuit 320. The at least one processor 310 and the at least one interface circuit 320 may be interconnected through a line. The processor 310 is configured to support the chip system in implementing functions or steps (for example, the control method recorded in FIG. 17) in the foregoing method embodiments. The at least one interface circuit 320 may be configured to receive a signal from another apparatus (for example, a communication interface, a radio frequency processing system, a baseband processing circuit, a power amplifier, or an antenna), or send a signal to another apparatus (for example, a communication interface, a radio frequency processing system, a baseband processing circuit, a power amplifier, or an antenna). The chip system 300 may include a chip, and may further include another discrete component.

Embodiments of this application further provide a computer-readable storage medium. The computer-readable storage medium includes instructions. When the instructions are run on a processor, the processor is caused to perform the control method (for example, the control method recorded in FIG. 17) described in the foregoing embodiments.

The processor and the controller involved in embodiments of this application may be a chip. For example, the processor may be a field programmable gate array (field programmable gate array, FPGA), an application specific integrated chip (application specific integrated circuit, ASIC), a system on chip (system on chip, SoC), a central processor unit (central processor unit, CPU), a network processor (network processor, NP), a digital signal processor (digital signal processor, DSP), a micro controller unit (micro controller unit, MCU), a programmable logic device (programmable logic device, PLD), or another integrated chip.

It should be understood that sequence numbers of the foregoing processes do not mean execution sequences in various embodiments of this application. The execution sequences of the processes should be determined according to functions and internal logic of the processes, and should not be construed as any limitation on the implementation processes of embodiments of this application.

A person of ordinary skill in the art may be aware that, in combination with the examples described in embodiments disclosed in this specification, modules and algorithm steps may be implemented by electronic hardware or a combination of computer software and electronic hardware. Whether the functions are performed by hardware or software depends on particular application and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and module, refer to a corresponding process in the foregoing method embodiments, and details are not described herein again.

In the several embodiments provided in this application, it should be understood that the disclosed system, device, and method may be implemented in other manners. For example, the described device embodiments are merely examples. For example, division into the modules is merely logical function division and may be other division in an actual implementation. For example, a plurality of modules or components may be combined or integrated into another device, or some features may be ignored or not performed. In addition, the displayed or discussed mutual couplings or direct couplings or communication connections may be implemented through some interfaces. The indirect couplings or communication connections between the devices or modules may be implemented in electronic, mechanical, or other forms.

The modules described as separate parts may or may not be physically separate, and parts displayed as modules may or may not be physical modules, that is, may be located in one device, or may be distributed on a plurality of devices. Some or all the modules may be selected according to actual needs to achieve the objectives of the solutions of embodiments.

In addition, functional modules in embodiments of this application may be integrated into one device, or each of the modules may exist alone physically, or two or more modules are integrated into one device.

All or some of the foregoing embodiments may be implemented by using software, hardware, firmware, or any combination thereof. When embodiments are implemented by using a software program, all or some of embodiments may be implemented in a form of a computer program product. The computer program product includes one or more computer instructions. When the computer program instructions are loaded and executed on a computer, all or some of the procedure or functions according to embodiments of this application are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (Digital Subscriber Line, DSL)) or wireless (for example, infrared, radio, or microwave) manner. The computer-readable storage medium may be any usable medium accessible by the computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid-state disk (solid-state disk, SSD)), or the like.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power amplifier, comprising a gate bias circuit, a drain bias circuit, and at least one power transistor, wherein the drain bias circuit is coupled to a drain of the at least one power transistor, the gate bias circuit comprises a first power supply interface and a second power supply interface, a specific voltage difference exists between a first voltage signal received by an input end of the first power supply interface and a second voltage signal received by an input end of the second power supply interface, and a gate of the at least one power transistor is configured to receive a radio frequency signal, and the radio frequency signal carries a plurality of signal slice symbols; and
when a first signal slice symbol carries valid data, the gate of the at least one power transistor is coupled to an output end of the first power supply interface; or
when the first signal slice symbol carries no valid data or no radio frequency signal is received, the gate of the at least one power transistor is coupled to an output end of the second power supply interface.

2. The power amplifier according to claim 1, wherein the gate bias circuit further comprises a voltage adjusting circuit, and the voltage adjusting circuit is configured to:
when the first signal slice symbol carries the valid data, adjust a magnitude of the first voltage signal to a first voltage value, wherein the first voltage value corresponds to a data volume range within which the valid data carried on the first signal slice symbol is.

3. The power amplifier according to claim 2, wherein the voltage adjusting circuit is a voltage divider circuit, the voltage divider circuit comprises a plurality of voltage divider output ends, and the plurality of voltage divider output ends are in one-to-one correspondence with a plurality of data volume ranges; and
when the first signal slice symbol carries the valid data and a data volume of the valid data is within a first data volume range, an input end of the voltage divider circuit is coupled to the output end of the first power supply interface, the gate of the at least one power transistor is in conduction with a first voltage divider output end, and the first voltage divider output end is a voltage divider output end corresponding to the first data volume range.

4. The power amplifier according to claim 3, wherein the voltage divider circuit comprises a resistor ladder; the resistor ladder comprises a plurality of equivalent resistors; the plurality of equivalent resistors are connected in series; a first end of the resistor ladder is the input end of the voltage divider circuit; and the plurality of equivalent resistors are coupled to the plurality of voltage divider output ends respectively.

5. The power amplifier according to claim 3 or 4, wherein the power amplifier further comprises a first gating switch, and the plurality of voltage divider output ends are coupled to the gate of the at least one power transistor via the first gating switch.

6. The power amplifier according to claim 5, wherein
when the first signal slice symbol carries no valid data or no radio frequency signal is received, the first gating switch is directly connected to the output end of the second power supply interface.

7. The power amplifier according to claim 2, wherein the gate bias circuit comprises a first power supply; an output end of the first power supply is coupled to the input end of the first power supply interface; the voltage adjusting circuit comprises a plurality of reference power supplies; a plurality of reference output ends corresponding to the plurality of reference power supplies are configured to output a plurality of reference voltages; and the plurality of reference voltages have different voltage values, and the plurality of reference voltages correspond to a plurality of data volume ranges, wherein
when the first signal slice symbol carries the valid data and a data volume of the valid data is within a first data volume range, a voltage input end of the first power supply is coupled to a first reference output end, and the first reference output end is a reference output end corresponding to the first data volume range.

8. The power amplifier according to claim 7, wherein the power amplifier further comprises a first gating switch; and the plurality of reference output ends corresponding to the plurality of reference power supplies are coupled to the voltage input end of the first power supply via the first gating switch.

9. The power amplifier according to claim 7 or 8, wherein the plurality of reference power supplies are a plurality of digital registers.

10. The power amplifier according to any one of claims 2 to 9, wherein when data volumes carried on a plurality of adjacent signal slice symbols are within at least two data volume ranges, a second data volume range serves as an actual data volume range of the plurality of adjacent signal slice symbols, and the second data volume range is a highest data volume range in the at least two data volume ranges.

11. The power amplifier according to any one of claims 1 to 10, wherein the power amplifier further comprises a second gating switch, and the gate of the at least one power transistor is coupled, via the second gating switch, to the output end of the first power supply interface or to the output end of the second power supply interface.

12. A control method, based on a power amplifier, wherein the power amplifier comprises at least one power transistor, and the method comprises:
receiving, by a gate of the at least one power transistor, a radio frequency signal and a gate bias voltage signal; and receiving, by a drain of the at least one power transistor, a drain bias voltage signal, wherein the radio frequency signal carries a plurality of signal slice symbols; and
controlling, when a first signal slice symbol carries valid data, the gate bias voltage signal to be a first voltage signal based on a control signal; or
controlling, when the first signal slice symbol carries no valid data or no radio frequency signal is received, the gate bias voltage signal to be a second voltage signal based on the control signal, wherein a specific voltage difference exists between the first voltage signal and the second voltage signal.

13. The control method according to claim 12, wherein the method further comprises:
adjusting, when the first signal slice symbol carries the valid data, a magnitude of the first voltage signal to a first voltage value based on the control signal, wherein the first voltage value corresponds to a data volume range within which the valid data carried on the first signal slice symbol is.

14. The control method according to claim 13, wherein the adjusting the magnitude of the first voltage signal to the first voltage value based on the control signal further comprises:
setting, when data volumes carried on a plurality of adjacent signal slice symbols are within at least two data volume ranges, a voltage value of the first voltage signal to a voltage value corresponding to a second data volume range, wherein the second data volume range is a highest data volume range in the at least two data volume ranges.

15. The control method according to any one of claims 12 to 14, wherein the method further comprises:
inputting a first indication signal, wherein the first indication signal indicates a data volume of valid data carried on the plurality of signal slice symbols; and
obtaining the control signal based on the first indication signal.

16. A radio frequency processing system, comprising a radio frequency generation circuit and the power amplifier according to any one of claims 1 to 11, wherein an output end of the radio frequency generation circuit is coupled to an input end of the power amplifier, the radio frequency generation circuit is configured to output a radio frequency signal, the radio frequency signal carries a plurality of signal slice symbols, and the power amplifier is configured to perform power amplification on the radio frequency signal.

17. A signal transmission apparatus, comprising a baseband processing circuit and the radio frequency processing system according to claim 16, wherein a first output end of the baseband processing circuit is coupled to a first input end of the radio frequency processing system, the first output end of the baseband processing circuit is configured to output a first baseband signal, the first baseband signal comprises a plurality of signal slice symbols, and the radio frequency processing system is configured to modulate the first baseband signal to obtain a radio frequency signal and output the radio frequency signal.

18. The signal transmission apparatus according to claim 17, wherein the baseband processing circuit comprises a controller, the controller is configured to output a control signal to the radio frequency processing system, and the control signal is used for adjusting a magnitude of a gate bias voltage signal of a power transistor of the radio frequency processing system.

19. The signal transmission apparatus according to claim 17, wherein a second output end of the baseband processing circuit is coupled to the first input end of the radio frequency processing system; the second output end of the baseband processing circuit is configured to output a first indication signal; and the first indication signal indicates a data volume of valid data carried on the plurality of signal slice symbols.

20. A computer-readable storage medium, wherein the computer-readable storage medium comprises instructions, and when the instructions are run on a processor, the processor is caused to perform the control method according to any one of claims 12 to 15.
